# EUROPÄISCHE PATENTSCHRIFT

(11) **EP 3 503 320 B1**
(45) Veröffentlichungstag und Bekanntmachung des Hinweises auf die Patenterteilung: **16.12.2020**
(21) Anmeldenummer: 17208666.2
(22) Anmeldetag: 19.12.2017
(51) Int. Cl.: H02B 1/28, A47B 81/00, G08B 7/06, E05G 1/024

(54) **BRANDSCHUTZGEHÄUSE**
FIRE-RESISTANT HOUSING
BOÎTIER IGNIFUGE

(43) Veröffentlichungstag der Anmeldung: 26.06.2019
(73) Patentinhaber: DIN-Dietmar Nocker Facilitymanagement GmbH, 4030 Linz (AT)
(72) Erfinder:
(74) Vertreter: Jell, Friedrich

(56) Entgegenhaltungen:
- DE-U1-202017 106 548
- US-A1- 2016 273 259

## Beschreibung

Die Erfindung betrifft ein Brandschutzgehäuse, insbesondere Brandschutzschrank, mit einem mindestens eine Korpuswand aufweisenden Korpus, der mehrere über Nut-Federverbindungen zusammensteckbare Korpuselemente aufweist, welche Korpuselemente je einen Plattenverbund aus mehreren miteinander verbundenen Platten aufweisen.

Ein modulartiger Aufbau eines aus Korpuselementen zusammengesteckten Brandschutzschranks ist aus der US2148689A bekannt. Die Korpuselemente weisen einen Verbund aus Außenblech und brandhemmender Isolation auf und werden über eine Nut-Feder-Verbindung im Stoß miteinander verbunden. Nachteilig sind die ganze Wandteile ausbildenden Korpuselemente vergleichsweise gewichtsbelastet und sperrig, was den Transport und den Zusammenbau des Brandschutzgehäuses am Aufstellungsort erschwert.

DE202017106548U1 betrifft ein Brandschutzgehäuse, insbesondere einen Brandschutzschrank. US2016/273259A1 betrifft auch ein Brandschutzgehäuse.

Die Erfindung hat sich daher die Aufgabe gestellt, ein eingangs geschildertes Brandschutzgehäuse bei einfacher Handhabbarkeit in der Modularität zu erhöhen. Die Erfindung löst die gestellte Aufgabe durch die Merkmale des Anspruchs 1. Indem die Korpuswand mindestens ein erstes und ein zweites Korpuselement aufweist, die übereinander angeordnet über die Nut-Federverbindung zusammensteckbar sind, kann das Brandschutzgehäuse durch Teilung der Korpuswände in der Modularität verbessert werden. Trotz einer gegenüber dem Stand der Technik erhöhten Anzahl an Bauteilen muss aber vorteilhaft nicht mit einer verminderten Handhabbarkeit des modularen Brandschutzgehäuses gerechnet werden. Erfindungsgemäß wird nämlich vorgesehen, dass von dieser Nut-Federverbindung eine erste Nutwand des ersten Korpuselements abschnittsweise einen Vorsprung und eine zweite Nutwand des zweiten Korpuselement einen dazu komplementären Rücksprung aufweisen. Der sich damit ergebende Formschluss zwischen Vorsprung und Rücksprung führt nämlich beim Zusammenbau der Korpuselemente zu einer gegenseitigen Ausrichtung dieser - was stets die Herstellung einer formgenauen Korpuswand sicherstellt und damit auch im Stoß zwischen den Korpuswänden eine hohe Passung gewährleisten kann.

Damit lässt sich trotz erhöhter Modalität des Brandschutzgehäuses bei hoher Handhabungsfreundlichkeit ein reproduzierbarer Zusammenbau des Brandschutzgehäuses am Aufstellort gewährleisten.

Im Allgemeinen wird erwähnt, dass die Platten als Brandschutzplatten ausgebildet sein können. Als Brandschutzplatte ist beispielsweise eine Calciumsilikat-Platte und/oder Vermiculit-Platte, faserhaltige Platte etc. vorstellbar.

Die Ausrichtung der Korpuselemente zueinander kann weiter erleichtert werden, wenn der Formschluss zwischen Vorsprung und Rücksprung selbstzentrierend ausgebildet sind.

Solch eine Selbstzentrierung kann beispielsweise geschaffen werden, wenn der Vorsprung oder der Rücksprung einen trapez-, dreieck- oder kreisförmigen Verlauf aufweist. Zudem kann diese Formgebung verhältnismäßig konstruktiv einfach im Bereich der Nut-Federverbindung vorgesehen werden.

Das Zusammenstecken der Korpuselemente ist mit Sicht auf den Vorsprung bzw. Rücksprung erleichtert, wofür die erste und/oder zweite Nutwand jeweils von einer Platte des Plattenverbunds ausbildet wird.

Erfindungsgemäß weist der Plattenverbund mindestens drei Platten auf, was zu einer erhöhten mechanischen Stabilität am Korpuselement führt - und damit die Standfestigkeit des Brandschutzgehäuses erhöhen wird. Insbesondere kann vorgesehen sein, dass der Plattenverbund aus drei miteinander verbundenen Platten besteht, was ein ideales Verhältnis von Größe und Gewicht zu Brandbeständigkeit darstellen kann. Vorzugsweise sind die Platten dabei miteinander stoffschlüssig verbunden.

Erfindungsgemäß, um die Konstruktion des Brandschutzgehäuses, aber auch der Herstellungsaufwand der Korpuselemente weiter zu vereinfachen, wird bzw. werden die Nut und/oder Feder der Nut-Federverbindung durch einen Versatz mindestens einer Platte im Plattenverbund ausgebildet. Zudem kann dies den Zusammenbau des Korpuselement vereinfachen.

Der erfindungsgemäße Aufbau eines Brandschutzgehäuses ist selbst in jenen Fällen möglich, in denen mindestens zwei Platten des Plattenverbunds aus unterschiedlichen Werkstoffen bestehen. Derart ist auch solch ein Brandschutzgehäuse auch in seiner Brandbeständigkeit weiter erhöht.

Eine einfache Ausgestaltung des Brandschutzgehäuses kann sich ergeben, wenn die Korpuswand die Rückwand, die linke und/oder rechte Seitenwand des Brandschutzgehäuses ausbildet.

Stoßen die Korpuswände über einen ersten Stufenfalz aneinander, kann dies den Zusammenbau des Brandschutzgehäuses am Aufstellungsort erleichtern und auch für einen gasdichten Anschluss und/oder brückenfreie Wärmedämmung der Korpuswände sorgen.

Der Zusammenbau des Brandschutzgehäuses kann weiter erleichtert werden, wenn Deckel und Boden des Brandschutzgehäuses über einen zweiten Stufenfalz an den Korpus stoßen.

Ein gasdichter und/oder in Bezug auf die Wärmedämmung brückenfreier Stoß kann handhabungsfreundlich sichergestellt werden, wenn je zwei Korpuswände mindestens ein Montagewinkel verbindet, der mindestens ein schräg verlaufendes Langloch für Befestigungsmittel aufweist. Mit Hilfe des schräg verlaufenden Langlochs können nämlich die über den Montagewinkel verbundenen Korpuselemente aneinander gezogen werden, was Toleranzen im Stoß ausgleichen kann. Das erfindungsgemäße Brandschutzgehäuse kann sohin eine besonders hohe Brandbeständigkeit gewährleisten.

Eine besonders geschützte und konstruktiv einfach ausgeführte Be- und/oder Entlüftung des Brandschutzgehäuse kann ermöglicht werden, wenn das erste und zweite Korpuselement gemeinsam einen Kanal zur Belüftung des Brandschutzgehäuses ausbilden.

Das erfindungsgemäße Brandschutzgehäuse kann sich insbesondere bei einer Notbeleuchtungsanlage eignen.

In den Figuren ist beispielsweise der Erfindungsgegenstand anhand einer Ausführungsvariante näher dargestellt. Es zeigen
- Fig. 1: eine Frontansicht auf ein Brandschutzgehäuse,
- Fig. 2: eine Explosionsansicht zu einer Korpuswand der Fig. 1 und
- Fig. 3: eine Detailansicht auf einen Montagewinkel der Fig. 1.

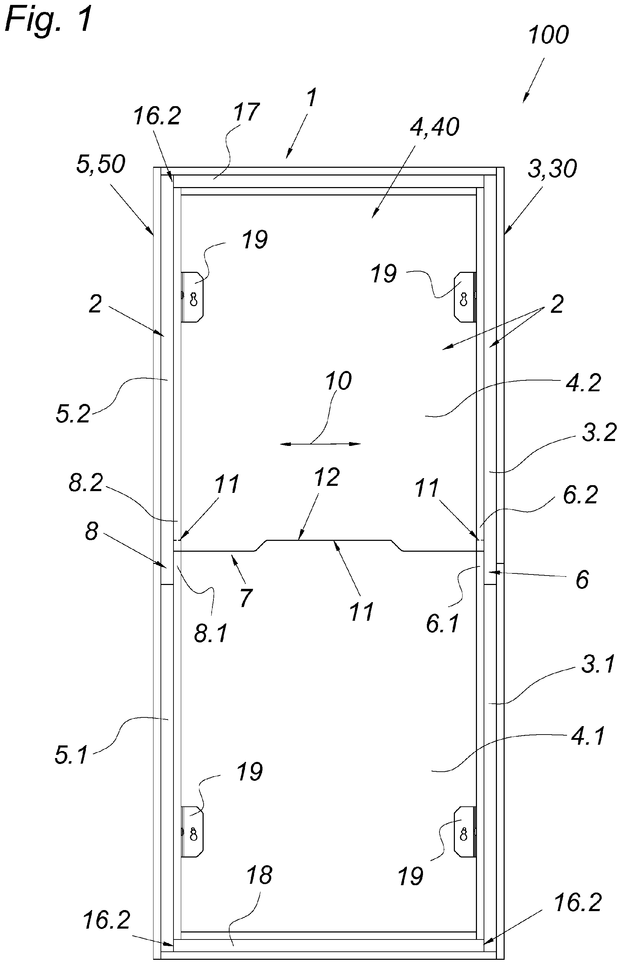

Nach Fig. 1 wird beispielsweise ein als Brandschutzschrank ausgeführtes Brandschutzgehäuse 1 einer nicht näher dargestellten Notbeleuchtungsanlage 100 gezeigt.

Das Brandschutzgehäuse 1 weist einen Korpus 2 mit drei Korpuswänden 3, 4 und 5 auf, die vom Brandschutzgehäuse die rechte Seitenwand 30, die Rückwand 40 und die linke Seitenwand 50 ausbilden. Die Gehäusetür ist der Übersichtlichkeit halber nicht dargestellt.

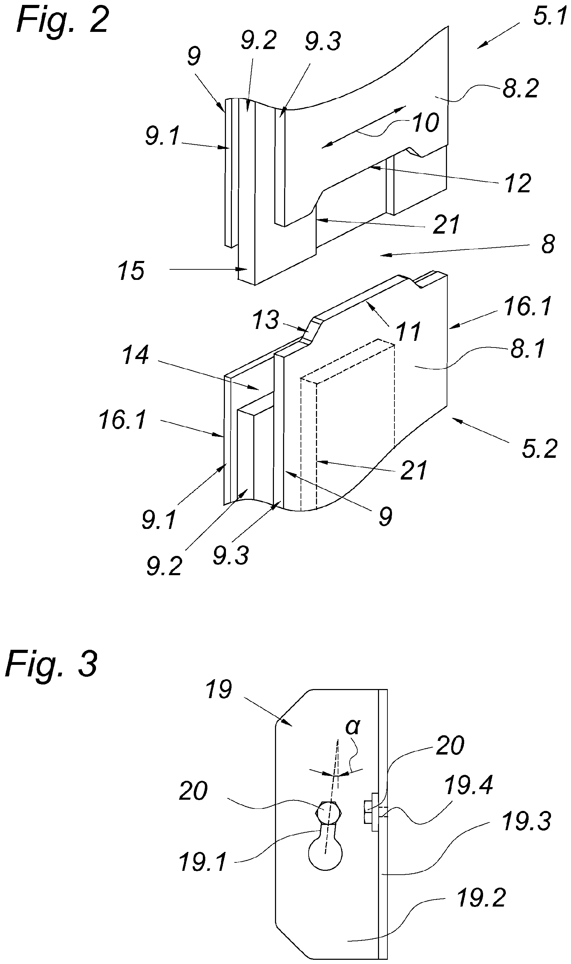

Der Korpus 2 wird durch Korpuselemente 3.1, 3.2 bzw. 4.1, 4.2 bzw. 5.1, 5.2 ausgebildet, welche über eine Nut-Feder Verbindungen 6, 7, 8 zusammensteckbar sind. Wie im dargestellten Beispiel nach Fig. 1 bzw. im Detail nach Fig. 2 zu entnehmen, bestehen die Korpuselemente 3.1, 3.2 bzw. 4.1, 4.2 bzw. 5.1, 5.2 je aus einem Plattenverbund 9 dreier Platten 9.1, 9.2, 9.3. Fig. 2 zeigt die Korpuselemente 5.1, 5.2 für alle Korpuselemente 3.1, 3.2, 4.1, 4.2, 5.1, 5.2 des Ausführungsbeispiels. Alle Platten 9.1, 9.2, 9.3 sind hierbei Brandschutzplatten - vorzugsweise weist die mittlere Platte 9.2 gegenüber den weiteren Platten 9.2, 9.3 einen anderen Werkstoff auf. Im aktuellen Beispiel ist die mittlere Platte 9.2 eine Calciumsilikat-Platte während die beiden äußeren Platten 9.1, 9.3 jeweils Gipsfaserplatte-Platte sind.

Erfindungsgemäß sind die Korpuswände 3, 4 und 5 zweigeteilt - wodurch jede Korpuswand 3, 4 und 5 jeweils ein erstes und ein zweites Korpuselement 3.1, 3.2 bzw. 4.1, 4.2 bzw. 5.1, 5.2 aufweist, die übereinander angeordnet bzw. die erste Nut-Federverbindung 6, 7, 8 zusammensteckbar sind. Dies erhöht die Modularität des Brandschutzgehäuses 1 erheblich, was den Transport zum bzw. von einem Aufstellungsort deutlich erleichtert.

Der Zusammenbau des Brandschutzgehäuses 1 am Aufstellungsort ist aufgrund der erfindungsgemäßen Nut-Federverbindung 6, 7, 8 der ersten Nutwand 6.1 bzw. 7.1 bzw. 8.1 besonders handhabungsfreundlich. So bildet diese erste Nutwand 6.1 bzw. 7.1 bzw. 8.1 am ersten Korpuselement 3.1 bzw. 4.1 bzw. 5.1 abschnittsweise einen Vorsprung 11 aus, welcher quer zur Längsrichtung 10 der jeweiligen Nut-Federverbindung 6, 7, 8 gerichtet ist. Die zweite Nutwand 6.2 bzw. 7.2 bzw. 8.2 am zweiten Korpuselement 3.2 bzw. 4.2 bzw. 5.2 bildet, einen dazu komplementären Rücksprung 12 aus, der quer zur Längsrichtung 10 der jeweiligen Nut-Federverbindung 6, 7, 8 gerichtet ist, wie dies insbesondere in der Fig. 2 zu erkennen ist.

Durch den derart erreichten, besonderen Formschluss zwischen den Nutwänden 6.1, 6.2 bzw. 7.1, 7.2 bzw. 8.1, 8.2 werden die ersten und zweiten Korpuselemente 3.2, 3.2 bzw. 4.1, 4.2 bzw. 5.1, 5.2 beim Zusammenstecken zueinander ausgerichtet - was eine besonders hohe Formgenauigkeit an den damit geschaffenen Korpuswänden 3, 4 und 5 ermöglicht. Diese Formgenauigkeit ist insbesondere für ein spaltfreies Brandschutzgehäuse 1 wichtig, um hohe Brandbeständigkeit sicherzustellen.

Entsprechend der Fig. 2 ist für die Nut-Federverbindung 8 - stellvertretend für alle anderen Nut-Federverbindung 6, 7, 8 der Korpuswände 3, 4 und 5 - erkennbar, dass die Form von Vorsprung 11 und Rücksprung 12 selbstzentrierend ausgebildet ist. Hierzu weist der Vorsprung 11 einen trapezförmigen Verlauf 13 auf, wodurch sich die betreffenden Korpuselemente 5.1, 5.2 beim Zusammenstecken unter anderem seitlich fluchtend ausrichten und so gemeinsam formgenaue Seitenkanten an der betreffenden Korpuswand 5 sicherstellen. Vorstellbar ist ebenso, dass Vorsprung 11 oder Rücksprung 12 zu dem genannten Zweck einen dreieck- oder kreisförmigen Verlauf 13 aufweisen, was nicht weiter dargestellt ist.

Wie insbesondere der Fig. 2 zu entnehmen, werden die erste und zweite Nutwand 6.1, 6.2 bzw. 7.1, 7.2 bzw. 8.1, 8.2 von je einer Platte 9.1 des Plattenverbunds 9 ausgebildet. Durch Versatz der mittleren Platten 9.2 gegenüber den äußeren Platten 9.1, 9.3 im jeweiligen Plattenverbund 9 bildet sich - zudem konstruktiv einfach gelöst - die Nut 14 oder die Feder 15 der Nut-Federverbindung 6, 7, 8 aus.

Hohe Brandbeständigkeit wird zudem dadurch erreicht, dass die betreffenden Korpuswände 6.1, 7.1, 8.1 über je einen ersten Stufenfalz 16.1 aneinander stoßen. Dies wird weiter verstärkt, indem auch Deckel 17 und Boden 18 des Brandschutzgehäuses 1 an den Korpus 2 über je einen zweiten Stufenfalz 16.2 anstoßen. Derart wird nämlich sichergestellt, dass am Brandschutzgehäuses stets Spaltfreiheit 1 besteht.

Vorstehendes wird insbesondere noch dadurch verstärkt und verbessert, indem zwischen zwei Korpuswänden 6.1, 7.1 bzw. 7.1, 8.1 jeweils mehrere Montagewinkel 19 vorgesehen sind, wie dies in Fig. 1 erkannt werden kann. Die Montagewinkel 19 weisen mindestens ein mit einem Schrägwinkel α zur Senkrechten schräg verlaufendes Langloch 19.1 auf einem Schenkel 19.2 für Befestigungsmittel 20 auf.

Beim Vorsehen des Montagewinkels 19 zwischen zwei Korpuswänden 6.1, 7.1 bzw. 7.1, 8.1, einem Befestigungsmittel 20 im Langloch 19.1 und einem anderen Befestigungsmittel 20 im Rundloch 19.4 im anderen Schenkel 19.3 kann der Montagewinkel 19 einer schrägen Bewegung unterworfen werden, beispielsweise durch eine Hammerbeaufschlagung. Durch diese schräge Bewegung des Montagewinkels 19 werden die diesbezüglichen Korpuselemente 3.1, 3.2, 4.1, 4.2, 5.1, 5.2 der Korpuswänden 6.1, 7.1 bzw. 7.1, 8.1 zusammengezogen, was in Bezug auf Wärmeleitung einen brückenfreien Formschluss sicherstellt. Nach einem Anziehen des Befestigungsmittels 20 wird die Lage der Korpuselemente 3.1, 3.2, 4.1, 4.2, 5.1, 5.2 gesichert. Die Befestigungsmittel 20 sind beispielsweise Kopfschrauben, etc.

Zudem weisen das erste und zweite Korpuselement 3.1, 3.2 bzw. 4.1, 4.2 bzw. 5.1, 5.2 Kanalteile auf, die bei zusammengesteckten Korpuselementen 3.1, 3.2 bzw. 4.1, 4.2 bzw. 5.1, 5.2 fluchten. Damit bilden das erste und zweite Korpuselement 3.1, 3.2 bzw. 4.1, 4.2 bzw. 5.1, 5.2 gemeinsam einen Kanal 21 zur Entlüftung des Brandschutzgehäuses 1, beispielsweise einer Batterie im Brandschutzgehäuse 1, aus.

## Patentansprüche

1. Brandschutzgehäuse, insbesondere Brandschutzschrank, mit einem mindestens eine Korpuswand (3, 4, 5) aufweisenden Korpus (2), der mehrere über Nut-Federverbindungen (6, 7, 8) zusammensteckbare Korpuselemente (3.1, 3.2 bzw. 4.1, 4.2 bzw. 5.1, 5.2) aufweist, welche Korpuselemente (3.1, 3.2 bzw. 4.1, 4.2 bzw. 5.1, 5.2) je einen Plattenverbund (9) aus mehreren miteinander verbundenen Platten (9.1, 9.2, 9.3) aufweisen, wobei die Korpuswand (3, 4, 5) mindestens ein erstes und ein zweites Korpuselement (3.1, 3.2 bzw. 4.1, 4.2 bzw. 5.1, 5.2) aufweist, die übereinander angeordnet über die Nut-Federverbindung (6, 7, 8) zusammensteckbar sind, wobei von dieser Nut-Federverbindung (6, 7, 8) eine erste Nutwand (6.1 bzw. 7.1 bzw. 8.1) des ersten Korpuselements (3.1 bzw. 4.1 bzw. 5.1) abschnittsweise einen Vorsprung (11) und eine zweite Nutwand (6.2 bzw. 7.2 bzw. 8.2) des zweiten Korpuselements (3.2 bzw. 4.2 bzw. 5.2) einen dazu komplementären Rücksprung (12) aufweisen, **dadurch gekennzeichnet, dass** der Plattenverbund (9) mindestens drei Platten (9.1, 9.2, 9.3) aufweist, wobei die Nut und/oder die Feder der Nut-Federverbindung (6, 7, 8) durch einen Versatz mindestens einer Platte (9.2) im Plattenverbund (9) ausgebildet wird bzw. werden.

2. Brandschutzgehäuse nach Anspruch 1, **dadurch gekennzeichnet, dass** der Formschluss zwischen Vorsprung (11) und Rücksprung (12) selbstzentrierend ausgebildet sind.

3. Brandschutzgehäuse nach Anspruch 2, **dadurch gekennzeichnet, dass** der Vorsprung (11) oder der Rücksprung (12) einen trapez-, dreieck- oder kreisförmigen Verlauf (13) aufweist.

4. Brandschutzgehäuse nach Anspruch 1, 2 oder 3, **dadurch gekennzeichnet, dass** die erste und/oder die zweite Nutwand (6.1, 6.2, 7.1, 7.2, 8.1, 8.2) jeweils von einer Platte (9.3) des Plattenverbunds (9) ausbildet wird.

5. Brandschutzgehäuse nach einem der Ansprüche 1 bis 4, **dadurch gekennzeichnet, dass** der Plattenverbund (9) aus drei, vorzugsweise stoffschlüssig, miteinander verbundenen Platten (9.1, 9.2, 9.3) besteht.

6. Brandschutzgehäuse nach Anspruch 1 oder 5, **dadurch gekennzeichnet, dass** mindestens zwei Platten (9.1, 9.2, 9.3) des Plattenverbunds (9) aus unterschiedlichen Werkstoffen bestehen.

7. Brandschutzgehäuse nach einem der Ansprüche 1 bis 6, **dadurch gekennzeichnet, dass** die Korpuswand (3, 4, 5) die Rückwand (40), die linke und/oder rechte Seitenwand (20, 50) des Brandschutzgehäuses (1) ausbildet.

8. Brandschutzgehäuse nach einem der Ansprüche 1 bis 7, **dadurch gekennzeichnet, dass** die Korpuswände (3, 4, 5) über einen ersten Stufenfalz (16.1) aneinander stoßen.

9. Brandschutzgehäuse nach einem der Ansprüche 1 bis 8, **dadurch gekennzeichnet, dass** Deckel (17) und Boden (18) des Brandschutzgehäuses (1) über einen zweiten Stufenfalz (16.2) an den Korpus (2) stoßen.

10. Brandschutzgehäuse nach einem der Ansprüche 1 bis 9, **dadurch gekennzeichnet, dass** je zwei Korpuswände (3, 4, 5) mindestens ein Montagewinkel (19) verbindet, der mindestens ein schräg verlaufendes Langloch (19.1) für Befestigungsmittel (20) aufweist.

11. Brandschutzgehäuse nach einem der Ansprüche 1 bis 10, **dadurch gekennzeichnet, dass** das erste und zweite Korpuselement (3.1, 3.2 bzw. 4.1, 4.2 bzw. 5.1, 5.2) gemeinsam einen Kanal (21) zur Be- und/oder Entlüftung des Brandschutzgehäuse (1) ausbilden.

12. Notbeleuchtungsanlage mit einem Brandschutzgehäuse (1) nach einem der Ansprüche 1 bis 11.

## Claims

1. Fire protection housing, in particular fire protection cabinet, having a body (2) which has at least one body wall (3, 4, 5) and a plurality of body elements (3.1, 3.2 or 4.1, 4.2 or 5.1, 5.2) which can be plugged together via tongue-and-groove connections (6, 7, 8), which body elements (3.1, 3.2 or 4.1, 4.2 or 5.1, 5.2) each comprise a plate composite (9) consisting of a plurality of interconnected plates (9.1, 9.2, 9.3), wherein the body wall (3, 4, 5) comprises at least one first and one second body element (3.1, 3.2 or 4.1, 4.2 or 5.1, 5.2), which are arranged one above the other and can be plugged together via the tongue-and-groove connection (6, 7, 8), wherein, of this tongue-and-groove connection (6, 7, 8), a first groove wall (6.1 or 7.1 or 8.1) of the first body element (3.1 or 4.1 or 5.1) has in sections a projection (11) and a second groove wall (6.2 or 7.2 or 8.2) of the second body element (3.2 or 4.2 or 5.2) has a set-back portion (12) complementary thereto, **characterized in that** the plate composite (9) has at least three plates (9.1, 9.2, 9.3), wherein the groove and/or the tongue of the tongue-and-groove connection (6, 7, 8) is/are formed by an offset of at least one plate (9.2) in the plate composite (9).

2. Fire protection housing according to claim 1, **characterized in that** the positive locking between projection (11) and set-back portion (12) is self-centering.

3. Fire protection housing according to claim 2, **characterized in that** the projection (11) or the set-back portion (12) has a trapezoidal, triangular or circular progression (13).

4. Fire protection housing according to claim 1, 2 or 3, **characterized in that** the first and/or the second groove wall (6.1, 6.2, 7.1, 7.2, 8.1, 8.2) is formed in each case by a plate (9.3) of the plate composite (9).

5. Fire protection housing according to one of the claims 1 to 4, **characterized in that** the plate composite (9) consists of three plates (9.1, 9.2, 9.3) which are preferably connected to one another in a materially bonded manner.

6. Fire protection housing according to claim 1 or 5, **characterized in that** at least two plates (9.1, 9.2, 9.3) of the plate composite (9) consist of different materials.

7. Fire protection housing according to one of claims 1 to 6, **characterized in that** the body wall (3, 4, 5) forms the rear wall (40), the left and/or right side wall (20, 50) of the fire protection housing (1).

8. Fire protection housing according to one of claims 1 to 7, **characterized in that** the body walls (3, 4, 5) abut each other via a first stepped rebate (16.1).

9. Fire protection housing according to one of claims 1 to 8, **characterized in that** the lid (17) and bottom (18) of the fire protection housing (1) abut the body (2) via a second stepped rebate (16.2).

10. Fire protection housing according to one of claims 1 to 9, **characterized in that** at least one mounting bracket (19) connects two body walls (3, 4, 5) each, which mounting bracket (19) has at least one obliquely extending slot (19.1) for fastening means (20).

11. Fire protection housing according to one of claims 1 to 10, **characterized in that** the first and second body element (3.1, 3.2 or 4.1, 4.2 or 5.1, 5.2) together form a duct (21) for ventilation and/or aeration of the fire protection housing (1).

12. Emergency lighting system with a fire protection housing (1) according to one of the claims 1 to 11.

## Revendications

1. Boîtier coupe-feu, en particulier armoire coupe-feu, avec un corps (2) présentant au moins une paroi de corps (3, 4, 5) qui présente plusieurs éléments de corps (3.1, 3.2 ou 4.1, 4.2 ou 5.1, 5.2) pouvant être emboîtés à l'aide d'assemblages à rainure et languette (6, 7, 8), lesquels éléments de corps (3.1, 3.2 ou 4.1, 4.2 ou 5.1, 5.2) présentent chacun un assemblage de panneaux (9) fait de plusieurs panneaux (9.1, 9.2, 9.3) assemblés entre eux, dans lequel la paroi de corps (3, 4, 5) présente au moins un premier élément de corps et un deuxième (3.1, 3.2 ou 4.1, 4.2 ou 5.1, 5.2) qui peuvent être superposés et assemblés à l'aide de l'assemblage à rainure et languette (6, 7, 8), une première paroi de rainure (6.1 ou 7.1 ou 8.1) du premier élément de corps (3.1 ou 4.1 ou 5.1) de cet assemblage à rainure et languette (6, 7, 8) présentant par zones une saillie (11) et une deuxième paroi de rainure (6.2 ou 7.2 ou 8.2) du deuxième élément de corps (3.2 ou 4.2 ou 5.2) présentant un épaulement (12) complémentaire de celle-ci, **caractérisé en ce que** l'assemblage de panneaux (9) présente au moins trois panneaux (9.1, 9.2, 9.3), la rainure et/ou la languette de l'assemblage à rainure et languette (6, 7, 8) étant formés par un décalage d'au moins un panneau (9.2) dans l'assemblage de panneaux (9).

2. Boîtier coupe-feu selon la revendication 1, **caractérisé en ce que** l'engagement positif entre la saillie (11) et l'épaulement (12) est conçu pour être autocentré.

3. Boîtier coupe-feu selon la revendication 2, **caractérisé en ce que** la saillie (11) ou l'épaulement (12) présente un contour (13) trapézoïdal, triangulaire ou circulaire.

4. Boîtier coupe-feu selon la revendication 1, 2 ou 3, **caractérisé en ce que** la première paroi de rainure et/ou la deuxième (6.1, 6.2, 7.1, 7.2, 8.1, 8.2) sont formées chacune par un panneau (9.3) de l'assemblage de panneaux (9).

5. Boîtier coupe-feu selon l'une des revendications 1 à 4, **caractérisé en ce que** l'assemblage de panneaux (9) se compose de trois panneaux (9.1, 9.2, 9.3), de préférence assemblés entre eux par solidarité de matière.

6. Boîtier coupe-feu selon la revendication 1 ou 5, **caractérisé en ce qu'**au moins deux panneaux (9.1, 9.2, 9.3) de l'assemblage de panneaux (9) se composent de matériaux différents.

7. Boîtier coupe-feu selon l'une des revendications 1 à 6, **caractérisé en ce que** la paroi de corps (3, 4, 5) forme la paroi arrière (40), la paroi latérale de gauche et/ou celle de droite (20, 50) du boîtier coupe-feu (1).

8. Boîtier coupe-feu selon l'une des revendications 1 à 7, **caractérisé en ce que** les parois de corps (3, 4, 5) sont mises bout à bout les unes avec les autres à l'aide d'un premier assemblage sur battue (16.1).

9. Boîtier coupe-feu selon l'une des revendications 1 à 8, **caractérisé en ce que** le couvercle (17) et le fond (18) du boîtier coupe-feu (1) sont mis bout à bout avec le corps (2) à l'aide d'un deuxième assemblage sur battue (16.2).

10. Boîtier coupe-feu selon l'une des revendications 1 à 9, **caractérisé en ce que** les parois de corps (3, 4, 5) sont assemblées deux par deux par une équerre de montage (19) qui présente au moins un trou oblong oblique (19.1) pour des moyens de fixation (20).

11. Boîtier coupe-feu selon l'une des revendications 1 à 10, **caractérisé en ce que** le premier élément de corps et le deuxième (3.1, 3.2 ou 4.1, 4.2 ou 5.1, 5.2) forment ensemble un canal (21) pour l'aération et/ou l'extraction d'air du boîtier coupe-feu (1).

12. Installation d'éclairage de secours avec un boîtier coupe-feu (1) selon l'une des revendications 1 à 11.
